(19) Europäisches Patentamt / European Patent Office / Office européen des brevets

(11) **EP 4 493 942 B1**

(12) **FASCICULE DE BREVET EUROPEEN**

(45) Date de publication et mention
de la délivrance du brevet:
**04.02.2026   Bulletin 2026/06**

(21) Numéro de dépôt: **22835725.7**

(22) Date de dépôt: **13.12.2022**

(51) Classification Internationale des Brevets (IPC):
**G01R 15/18** *(2006.01)*      **G01R 19/00** *(2006.01)*

(52) Classification Coopérative des Brevets (CPC):
**G01R 15/186; G01R 19/0092**

(86) Numéro de dépôt international:
**PCT/EP2022/085493**

(87) Numéro de publication internationale:
**WO 2023/174572 (21.09.2023 Gazette 2023/38)**

(54) **CAPTEUR DE CHAMP MAGNETIQUE POUR LA MESURE D'UN COURANT CONTINU**

MAGNETFELDSENSOR ZUR MESSUNG EINES GLEICHSTROMS

MAGNETIC FIELD SENSOR FOR MEASURING A DIRECT CURRENT

(84) Etats contractants désignés:
**AL AT BE BG CH CY CZ DE DK EE ES FI FR GB GR HR HU IE IS IT LI LT LU LV MC ME MK MT NL NO PL PT RO RS SE SI SK SM TR**

(30) Priorité:   **18.03.2022   FR 2202411**

(43) Date de publication de la demande:
**22.01.2025   Bulletin 2025/04**

(73) Titulaire: **Socomec**
**67230 Benfeld (FR)**

(72) Inventeur: **KERN, Christian**
**68240 Kaysersberg-Vignoble (FR)**

(74) Mandataire: **Ipsilon**
**Boîte Postale CS 91455**
**34 Avenue du Général Leclerc**
**68071 Mulhouse Cedex (FR)**

(56) Documents cités:
**EP-B1- 3 314 281      US-B2- 10 495 605**

## Description

### Domaine technique

La présente invention concerne un dispositif de mesure sans contact d'un courant électrique circulant dans un conducteur par l'intermédiaire de la mesure du champ magnétique induit par ce courant. L'invention concerne plus particulièrement un capteur de champ magnétique intégrant un transducteur à base d'un matériau super-paramagnétique, adapté pour la mesure de courant continu.

### Technique antérieure

Pour mesurer un courant I, différents principes physiques peuvent être exploités pour générer une grandeur physique représentative de ce courant I. Par exemple, les capteurs magnétiques mettent en œuvre des transducteurs qui sont sensibles à des grandeurs magnétiques, tels que le champ magnétique, induites par le courant à mesurer.

On connaît notamment les capteurs de courant mettant en œuvre la technologie dite à Effet Néel® décrite par exemple dans le document FR2891917. La particularité de cette technologie repose sur l'utilisation d'un transducteur constitué de bobines dont les noyaux sont à base d'un composite chargé de nanoparticules présentant des propriétés super-paramagnétiques. Le matériau super-paramagnétique utilisé ayant la particularité d'être exempt d'hystérésis, ce type de transducteur présente ainsi l'avantage de ne pas présenter d'offset magnétique.

De façon simplifiée, la bobine à noyau super-paramagnétique (ou bobine SPM) agit comme un mélangeur de fréquences. Lorsqu'une bobine SPM est parcourue par un courant d'excitation de fréquence Fexc connu, et en l'absence de champ magnétique extérieur à mesurer Hext, la force électromotrice (f.é.m.) induite aux bornes de cette bobine ne présentera pas d'harmonique de rang pair. Au contraire, l'apparition d'un champ magnétique extérieur à mesurer Hext induira l'apparition d'harmoniques de rang pair portant l'information sur le champ magnétique à mesurer. En pratique, l'amplitude et la phase des harmoniques paires et en particulier celle de l'harmonique de rang 2 permettent respectivement d'accéder à l'amplitude et à la polarité du champ primaire. Un circuit de contre-réaction peut être couplé au système pour réduire d'éventuelles informations parasites dues aux distorsions induites par le système, et délivrer une grandeur de mesure plus exploitable, par exemple directement proportionnelle au courant à mesurer.

Un tel capteur de courant est par exemple décrit de manière succincte dans le document FR2980581, mais la configuration proposée suppose l'utilisation d'un générateur de signaux spécifique capable de générer un signal d'excitation d'onde idéal, c'est-à-dire un signal dont les amplitudes des harmoniques paires sont nulles. Or, un signal généré par l'intermédiaire d'un générateur de type PWM (« pulse width modulation » ou « modulation à largeur d'impulsion ») ou d'un convertisseur analogique-numérique (CAN) contient nécessairement des harmoniques, et notamment l'harmonique de rang 2 dont le niveau peut être non négligeable et qui se retrouve dans le signal fourni par la bobine SPM, nécessitant la mise en œuvre d'un traitement complexe pour extraire le signal utile.

Le document FR3038063 propose un capteur intégrant un transducteur formé de quatre bobines SPM et couplé à deux générateurs d'excitation, à savoir un générateur haute fréquence $F_{HF}$ de courant $I_{HF}$ et un générateur basse fréquence $F_{BF}$ de courant $I_{BF}$. Le capteur est notamment configuré pour que les bobines soient parcourues par des courants d'excitation qui permettent d'obtenir au niveau de la sortie du transformateur un signal ne contenant que les fréquences utiles $F_{HF}-F_{BF}$ et $F_{HF}+F_{BF}$. De cette manière, même en présence de résidus harmoniques dans les signaux $I_{HF}$ et $I_{BF}$, le signal utile en sortie notamment du transformateur utilisé pour la détection n'est pas affecté par la qualité des signaux d'excitation. Cette configuration impose cependant de choisir une fréquence $F_{BF}$ très inférieure à la fréquence $F_{HF}$, de sorte que les deux fréquences présentes dans le signal utile de sortie sont relativement proches et distantes de $2.F_{BF}$ seulement. Ce faible écart fréquentiel conduit à la nécessité d'utiliser un filtre de démodulation de fréquence de coupure relativement basse, notamment inférieure à $2.F_{BF}$, ce qui engendre un temps de réponse long et à une bande passante limitée du système. Par ailleurs, le déséquilibre inévitable des bobines SPM provoquera également l'apparition d'une composante à la fréquence $F_{HF}$ proche des deux fréquences utiles $F_{HF}-F_{BF}$ et $F_{HF}+F_{BF}$. La forte amplification des fréquences utiles pour obtenir un bon rapport signal sur bruit étant nécessaire, la présence de cette composante $F_{HF}$ est donc gênante et difficile à filtrer à cause de sa proximité avec les fréquences utiles. Un filtre coupe-bande sélectif peut être ajouté pour limiter le problème, mais outre la réalisation complexe et délicat d'un tel filtre sélectif, son intégration accroît le temps de réponse du système. Par ailleurs, l'utilisation de deux générateurs d'excitation pour l'injection des deux fréquences induit un coût non négligeable à la solution.

### Exposé de l'invention

L'objet de la présente invention vise donc à proposer une solution alternative de capteur de champ magnétique continu ou de courant continu, intégrant des bobines à noyau super-paramagnétique. L'invention vise notamment à proposer une configuration permettant d'améliorer le rapport signal sur bruit du système, qui ne nécessite pas l'utilisation de composants très couteux, ni la mise en œuvre de circuits encombrants, ni une réalisation complexe.

L'invention a ainsi pour objet un capteur de champ magnétique pour la mesure d'un courant continu, formé d'au moins un transducteur à matériau super-paramagnétique SPM destiné à être soumis à un champ magnétique extérieur à mesurer, et couplé électriquement à un module d'excitation et à un module d'analyse.

Selon l'invention, le transducteur comprend au moins une paire de bobines à noyau super-paramagnétique SPM, les bobines SPM étant sensiblement identiques et étant connectées en série entre deux bornes extrêmes du transducteur, le point de connexion commun des bobines SPM étant relié à un potentiel de référence.

En outre, le module d'excitation est configuré pour générer et injecter dans le transducteur un courant d'excitation Ie à une fréquence d'excitation Fe prédéfinie, et comprend au moins :

- une bobine à point milieu montée en parallèle aux bornes du transducteur ;
- un générateur de tension d'excitation monté entre le potentiel de référence et ledit point milieu, ce générateur de tension étant de préférence à fréquence ajustable ou réglable ; et
- une impédance d'excitation configurée pour former avec les bobines SPM un premier circuit de type RLC série de fréquence de résonance Fres_e sensiblement égale à la fréquence d'excitation Fe.

Par ailleurs, le module d'analyse comprend au moins :

- une impédance d'analyse connectée aux bornes extérieures de la bobine à point milieu, l'impédance d'analyse étant configurée pour former avec les bobines SPM un deuxième circuit de type RLC série de fréquence de résonance d'analyse Fres_a sensiblement égale à une fréquence d'analyse Fa ; et
- un moyen d'analyse du courant traversant l'impédance d'analyse à la fréquence d'analyse Fa pour extraire une composante à ladite fréquence d'analyse Fa égale à un multiple pair de la fréquence d'excitation Fe.

Avantageusement, la fréquence d'analyse Fa est égale à 2.Fe.

Selon un mode de réalisation, l'impédance d'excitation est connectée entre le générateur d'excitation et le point milieu de la bobine à point milieu.

Selon un autre mode de réalisation, l'impédance d'excitation est connectée entre le potentiel de référence et le point de connexion commun des bobines SPM.

Selon une variante, l'impédance d'excitation comprend au moins un condensateur d'excitation.

Selon une autre variante, l'impédance d'excitation comprend au moins un condensateur d'excitation et une inductance d'excitation, l'inductance d'excitation étant connectée entre le condensateur d'excitation et le générateur de tension d'excitation.

En pratique, la bobine à point milieu peut être constituée de deux enroulements sensiblement identiques bobinés sur un même noyau magnétique.

Avantageusement, l'impédance d'analyse peut être constituée par un condensateur d'analyse et une résistance d'analyse montés en série entre les deux bornes extérieures de la bobine à point milieu.

L'impédance d'analyse peut également comprendre une inductance d'analyse montée en série avec le condensateur d'analyse et la résistance d'analyse entre les bornes extérieures de la bobine à point milieu.

Selon un autre mode de réalisation, le capteur de champ magnétique peut en outre comprendre un transformateur monté entre la bobine à point milieu et l'impédance d'analyse, ledit transformateur étant constitué par un enroulement primaire et un enroulement secondaire, l'enroulement primaire étant connectée aux bornes extérieures de la bobine à point milieu, et l'enroulement secondaire étant connecté aux bornes de l'impédance d'analyse.

Selon un autre mode de réalisation, le capteur champ magnétique peut en outre comprendre un transformateur comprenant un enroulement primaire formé de la bobine à point milieu et d'un enroulement secondaire connecté aux bornes de l'impédance d'analyse.

Selon un autre mode de réalisation, les bobines SPM du transducteur forme une première paire de bobines SPM, et le capteur peut en outre comprendre une deuxième paire de bobines SPM sensiblement identique à ladite première paire de bobines SPM. Dans cet autre mode de réalisation, les bobines SMP de la deuxième paire sont montées en série, la borne extrême de la première paire de bobines SPM est connectée à l'une des bobines de la deuxième paire, et la borne extrême de la première paire de bobine SPM est connectée à l'autre bobine de la deuxième paire.

Avantageusement, le capteur peut en outre comprendre un module de contre-réaction formé d'au moins un générateur de tension de contre-réaction configuré pour générer un courant de contre-réaction. Dans le cas d'un capteur à deux bobines SPM, le générateur de tension de contre-réaction est de préférence monté aux bornes extrêmes du transducteur, et dans le cas d'un capteur à quatre bobines SPM, le générateur de tension de contre-réaction est de préférence monté entre les bobines SPM de la deuxième paire et configuré pour générer un courant de contre-réaction.

Selon une variante, le générateur de tension de contre-réaction peut être formé de deux sources de tension référencées au potentiel de référence.

Selon un autre mode de réalisation, le capteur de champ magnétique peut en outre comprendre un module de calibration configuré pour rechercher une valeur optimale Fopt de la fréquence d'excitation Fe à injecter dans le transducteur.

Dans une variante, le module de calibration peut être configuré pour :

- faire varier la fréquence d'excitation Fe du générateur d'excitation dans une plage de fréquences [Fe_min ; Fe_max] et mesurer les courants d'excitation le correspondants ; et
- identifier la fréquence optimale d'excitation Fopt_e correspondant à la fréquence d'excitation Fe pour laquelle le niveau de courant d'excitation le est maximum.

Par exemple, le module de calibration peut être configuré pour mesurer le courant d'excitation aux bornes d'une résistance montée entre le potentiel de référence et le point commun de connexion des bobines SPM du transducteur.

Le module de calibration peut également être configuré pour mesurer le courant d'excitation aux bornes du condensateur d'excitation lorsque l'impédance d'excitation est montée entre le potentiel de référence et le point de connexion commun des deux bobines SPM du transducteur.

Dans une autre variante, le module de calibration peut être configuré pour :

- faire varier la fréquence d'excitation Fe du générateur d'excitation dans une plage de fréquences [Fe_min ; Fe_max] et mesurer la sensibilité S du module d'excitation ;
- identifier la fréquence optimale d'excitation Fopt_e correspondant à la fréquence d'excitation Fe pour laquelle ladite sensibilité S est maximale.

**Brève description des dessins**

D'autres caractéristiques et avantages de la présente invention apparaîtront plus clairement à la lecture de la description qui va suivre, faite en référence aux dessins annexés, donnés à titre d'exemples non limitatifs, dans lesquels :

- La figure 1 est un schéma électronique simplifié du capteur selon un mode de réalisation, dans lequel l'impédance Ze est formée d'un condensateur Ce.
- La figure 2 est un schéma électronique simplifié du capteur selon un autre mode de réalisation, dans lequel une inductance Le est ajoutée à l'impédance d'excitation Ze.
- La figure 3 est un schéma électronique simplifié du capteur selon un autre mode de réalisation, dans lequel une inductance La est ajoutée à l'impédance d'analyse Za.
- La figure 4 est un schéma électronique simplifié du capteur selon un autre mode de réalisation, dans lequel un transformateur d'adaptation T1 est ajouté.
- La figure 5 est un schéma électronique simplifié du capteur selon un autre mode de réalisation, dans lequel les fonctions du transformateur T1 et de la bobine à point milieu de la figure 4 sont regroupées dans un seul composant T2.

- La figure 6 est un schéma électronique simplifié du capteur selon un autre mode de réalisation, dans lequel l'impédance d'excitation Ze est montée entre la borne commune du transducteur et le potentiel commun.
- La figure 7 est un schéma électronique simplifié du capteur selon un autre mode de réalisation, comprenant deux bobines SPM supplémentaires.
- La figure 8 est un schéma électronique simplifié du capteur de la figure 7 comprenant un circuit de contre-réaction, selon un autre mode de réalisation.
- La figure 9 est un schéma électronique simplifié du capteur de la figure 7 comprenant un circuit de contre-réaction, selon un autre mode de réalisation.
- La figure 10 est un diagramme sommaire des étapes de la calibration pour la recherche de la fréquence optimale d'excitation, selon une méthodologie.
- La figure 11 est un diagramme sommaire des étapes de la calibration pour la recherche de la fréquence optimale d'excitation, selon une autre méthodologie.
- La figure 12 est un graphique montrant l'atténuation à la fréquence d'analyse Fa d'un signal parasite présent dans la tension d'excitation, avec l'ajout de l'inductance Le de la figure 2.
- La figure 13 est un graphique illustrant la différence de sélectivité recherchée entre l'excitation et l'analyse, selon un mode de réalisation.

**Description des modes de réalisation**

Un capteur de l'invention comprend un transducteur formé d'au moins une paire de bobines à noyau super-paramagnétique (SPM par la suite) couplé à un module d'excitation et à un module conditionneur ou module d'analyse. Le transducteur est destiné à être soumis à un champ magnétique extérieur à mesurer. En pratique, le champ magnétique extérieur à mesurer inclut les fréquences allant du continu à une fréquence sensiblement inférieure à la fréquence d'excitation, de préférence au moins dix fois plus faible. Le module d'excitation est configuré pour générer et injecter dans le transducteur un signal d'excitation, par exemple sous la forme d'un courant dit « d'excitation » de fréquence correspondant à une fréquence d'excitation Fe prédéfinie. Le module conditionneur est configuré pour récupérer et analyser un signal de mesure SPM brut, par exemple la f.é.m. aux bornes du transducteur, représentatif de la variation temporelle de l'induction magnétique dans les bobines SPM. L'analyse de ce signal SPM brut consiste notamment en la génération d'un signal utile facilement exploitable contenant les informations utiles représentatives du champ magnétique ou du courant à mesurer. L'analyse comprend par exemple l'élimination des composantes fréquentielles indésirables du signal SPM pour ne garder que la composante fréquentielle utile du signal SPM.

Ainsi contrairement à la solution décrite dans le document FR3038063A1, une seule fréquence d'excitation Fe, notamment une haute fréquence d'excitation, est utilisée dans le capteur, et les informations utiles relatives au champ magnétique ou courant à mesurer se trouvent donc dans les harmoniques de rang pair du signal de mesure SPM. De ce fait, l'analyse du signal SPM peut consister à isoler ou à extraire la composante fréquentielle située à un multiple pair de la fréquence d'excitation Fe. En d'autres termes, l'analyse du signal SPM doit être effectuée à une fréquence d'analyse Fa égale à un multiple pair de la fréquence d'excitation Fe, de préférence à la fréquence 2.Fe pour laquelle le niveau du signal SPM est maximum.

En pratique, l'injection d'une unique fréquence d'excitation Fe dans les bobines SPM impose l'utilisation d'un signal d'excitation de qualité afin de limiter au maximum les signaux parasites susceptibles de se retrouver dans le signal de mesure SPM brut et susceptibles de complexifier son traitement ou l'extraction des informations utiles.

En particulier, un signal parasite à la fréquence d'excitation Fe peut apparaître au niveau de la chaine de réception du module conditionneur. Il est cependant possible de réduire son niveau de manière relativement simple sans trop affecter le temps de réponse du système, car l'écart entre la fréquence d'analyse Fa et la fréquence parasite est égal à Fe. Un filtre de sélectivité faible à moyenne n'affectant pas trop la bande passante du système pourra par exemple être utilisé.

Par ailleurs, les bobines SPM agissant comme un mélangeur de fréquence, la présence de composantes harmoniques dans le courant d'excitation peut induire, dans le signal de mesure SPM, des composantes parasites de niveau non négligeable susceptible de noyer la composante utile. A titre d'exemple, avec un champ d'excitation monofréquence de 500A/m et un champ à mesurer de 1A/m, la composante utile pour la mesure de l'effet super-paramagnétique (à savoir l'harmonique de rang 2 de la fréquence d'excitation, c'est-à-dire à la fréquence 2.Fe) a une amplitude de l'ordre de 20mA/m. Si le champ d'excitation présente un taux d'harmonique 2 de 0.01%, soit 50mA/m, le signal mesuré en absence de champ à mesurer correspond à environ 2.5A/m, donc largement supérieur à la composante utile. Or, obtenir un taux d'harmonique pour le rang 2 de 0.01% est particulièrement difficile et mesurer directement une composante représentant 0.004% du signal total est particulièrement délicat.

En pratique, cette deuxième harmonique dans le courant d'excitation est très difficile à éviter.

Par exemple, la génération d'un courant d'excitation avec des techniques de type à modulation de largeur d'impulsion, l'harmonique de rang 2 est nécessairement présent à cause des différences de temps de montée et de descente, mais aussi à cause des différences de résistances de sortie entre l'état haut et l'état bas.

Avec des techniques de génération de courant d'excitation à base de synthèse de signal par convertisseur numérique/analogique et amplificateur de puissance, les sources de l'harmonique 2 se trouvent dans les non-linéarités du convertisseur numérique/analogique et de l'amplificateur. Le filtrage actif du signal provenant du convertisseur numérique/analogique permet d'obtenir un signal à faible taux d'harmonique au rang 2 si le courant de sortie est faible. Or, le courant d'excitation nécessaire peut être compris entre quelques dizaines et quelques centaines de mA. Les amplificateurs disponibles dans le commerce offrant des faibles taux de distorsion pour ces niveaux de courant et ces fréquences sont rares et chers, et la réalisation d'un étage de puissance à composants discrets compatible avec les performances requises est complexe et encombrant.

Afin de pouvoir utiliser des amplificateurs du commerce bon marché ou un système à modulation de largeur d'impulsion, tout en garantissant un faible taux d'harmonique 2, une solution pour améliorer la qualité du signal d'excitation injecté dans les bobines SPM peut consister à insérer une impédance d'excitation Ze dans le circuit ou module d'excitation.

**Mode de réalisation à 2 bobines SPM, Ze = Ce**

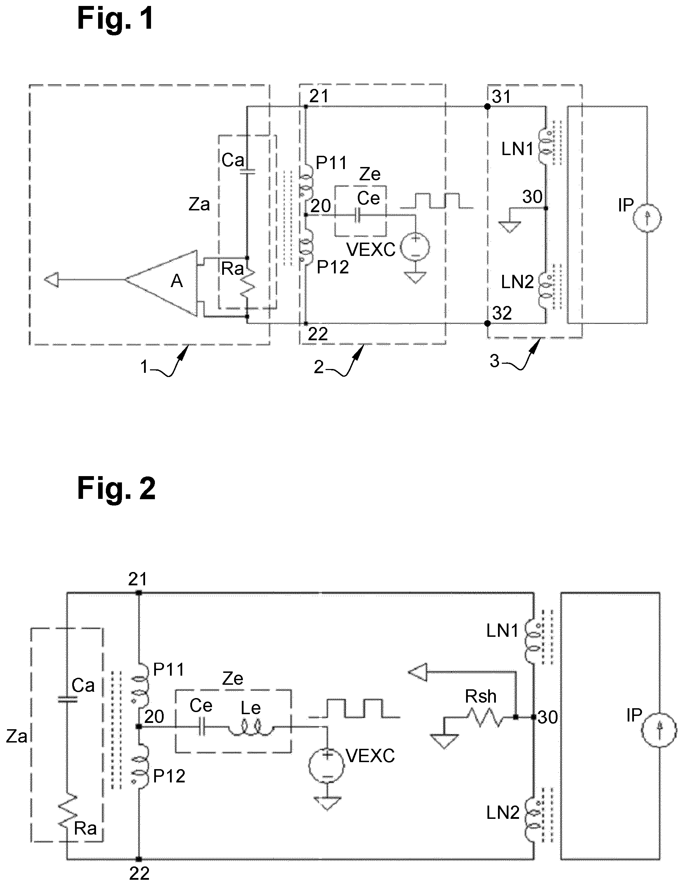

Un montage électronique du capteur selon un premier mode de réalisation est illustré à la figure 1, dans lequel une impédance d'excitation Ze comprenant un condensateur Ce, est ajoutée pour l'atténuation de la composante harmonique au rang 2, c'est-à-dire à 2.Fe, dans le signal d'excitation.

Le capteur comprend un transducteur 3 formé d'une paire de bobines SPM, identifiées respectivement par LN1 et LN2 sur la figure 1, d'inductance $L_N$, montées en série entre les deux bornes extrêmes 31, 32 du transducteur. Le point de connexion commun 30 au deux bobines LN1 et LN2 est connecté à un potentiel de référence, par exemple une masse. Les bobines LN1 et LN2 sont destinées à être soumises à un champ magnétique extérieur à mesurer induit par exemple par une source de courant primaire IP.

Le capteur comprend en outre un module d'excitation 2 couplé électriquement au transducteur 1 et configuré pour générer et injecter dans le transducteur 1 un courant d'excitation à une fréquence d'excitation Fe prédéfinie. Le module d'excitation 2 comprend :

- une bobine à point milieu P11-P12 constituée de deux enroulements sensiblement identiques bobinés sur un même noyau magnétique ;
- un générateur de tension d'excitation VEXC à une fréquence égale à la fréquence d'excitation Fe ;
- une impédance d'excitation Ze comprenant un condensateur Ce.

Les deux bornes extérieures 21, 22 de la bobine P11-P12 sont connectées respectivement aux deux bornes extrêmes 31, 32, du transducteur 3, le condensateur Ce de l'impédance d'excitation Ze est connecté entre le générateur d'excitation VEXC et le point milieu 20 de la bobine P11-P12.

Les bobines LN1 et LN2 du transducteur 3 constituent une charge de type de résistance/inductance (RL) série. L'insertion du condensateur Ce entre la bobine à point milieu P11-P12 et le générateur de tension d'excitation VEXC revient à charger celui-ci avec un circuit de type RLC série caractérisé par sa fréquence de résonnance Fres_e, dénommée par la suite « fréquence de résonnance d'excitation ». Cette fréquence de résonnance d'excitation Fres_e est définie par :

$$F_{res\_e} = \frac{1}{2\pi\sqrt{\frac{L_N}{2}C_e}}$$

Ainsi, si la valeur du condensateur Ce est telle que la fréquence de résonance Fres_e est sensiblement égale à la fréquence d'excitation Fe (Fres_e = Fe), ce circuit agira comme un filtre passe-bande sur le courant d'excitation et atténuera la composante harmonique du signal d'excitation à la fréquence 2.Fe. Cette atténuation dépend du facteur de qualité Q du circuit, donnée par l'expression suivante :

$$Q = \frac{2\pi.L.Fres\_e}{R} \ ;$$

En outre, le gain à 2.Fres_e est donné par :

$$G(2F_{res_e}) = \frac{2}{\sqrt{9Q^2 + 4}} \cong \frac{2}{3Q}$$

Le capteur comprend en outre un module d'analyse ou conditionneur 1 configuré pour récupérer et analyser un signal de mesure SPM brut afin d'éliminer des composantes fréquentielles indésirables du signal SPM et ne garder que la composante fréquentielle utile du signal SPM. Le module d'analyse 1 comprend :

- une impédance d'analyse Za constituée par un condensateur d'analyse Ca et une résistance d'analyse Ra montés en série entre les deux bornes extérieures 21, 22 de la bobine à point milieu P11-P12 ;
- une chaine d'analyse A configurée pour fournir un signal SPM contenant les informations utiles à 2.Fe qui soit exploitable par une unité de contrôle externe ou intégrée au capteur, cette chaîne d'analyse comprenant par exemple des circuits d'amplification et de filtrage.

Le courant traversant l'impédance d'analyse Za correspond ainsi au signal de mesure SPM brut et l'analyse de ce courant traversant l'impédance d'analyse Za à une fréquence d'analyse Fa égale à un multiple pair de la fréquence d'excitation Fe, par exemple à une fréquence d'analyse Fa égale à 2.Fe, permet d'isoler ou d'extraire un signal utile contenant les informations relatives au champ ou au courant à mesurer.

Comme pour le circuit d'excitation, la combinaison des bobines LN1 et LN2 et de l'impédance Za forme un circuit de type RLC série de fréquence de résonance Fres_a, dénommée par la suite « fréquence de résonance d'analyse ». Cette fréquence de résonance d'analyse vaut :

$$F_{res\_a} = \frac{1}{2\pi\sqrt{2L_N C_a}}$$

En pratique, la fréquence d'analyse Fa est avantageusement sensiblement égale à la fréquence de résonance d'analyse Fres_a.

## Mode de réalisation à 2 bobines SPM, Ze = Ce, Le

Un montage électronique du capteur selon un autre mode de réalisation est illustré à la figure 2, dans lequel l'impédance d'excitation Ze, comprend un condensateur Ce et une inductance Le.

Il est montré ci-avant que l'atténuation du niveau de l'harmonique de rang 2 dépend du facteur de qualité Q du circuit. Or par construction, les bobines SPM ont en général un facteur de qualité relativement médiocre aux fréquences considérées, de l'ordre 3 à 5, ce qui permettrait d'atteindre une atténuation (l'inverse du gain) de l'ordre 4 à 8. Pour améliorer cette atténuation, il est possible d'ajouter au montage de la figure 1, une inductance d'excitation Le (par exemple une bobine) à facteur de qualité élevé, de valeur d'inductance sensiblement plus élevée que celle des bobines SPM et de résistance négligeable devant celle des bobines SPM.

Le montage de la figure 2 correspond ainsi au montage de la figure 1 dans lequel l'impédance d'excitation Ze comprend en outre une inductance d'excitation Le connectée entre le condensateur d'excitation Ce et le générateur de tension d'excitation VEXC, afin d'améliorer le facteur de qualité de l'excitation pour diminuer le niveau de distorsion à la fréquence 2.fe.

Dans cette configuration, la fréquence de résonnance du circuit d'excitation Fres_e vaut maintenant :

$$F_{res\_e} = \frac{1}{2\pi\sqrt{\left(L_e + \frac{L_N}{2}\right)C_e}}$$

En outre, le facteur de qualité global du circuit est maintenant proche de celui de la bobine Le ainsi ajoutée. Il est ainsi possible d'atteindre un facteur de qualité de l'ordre de 30 à 50, ce qui conduit à des atténuations de l'ordre 45 à 75, soit dix fois plus qu'avec les seules bobines SPM.

De façon optionnelle, lorsque la mesure du courant d'excitation est nécessaire ou envisagée, une résistance de mesure du courant d'excitation Rsh peut être ajoutée entre le potentiel de référence et la borne commune 30 du transducteur. La mesure du coutant d'excitation est notamment utile lorsque l'on souhaite réaliser une étape de calibration préalable afin de rechercher la valeur optimale de la fréquence d'excitation à injecter dans les bobines SPM pour laquelle le niveau de courant d'excitation est maximum. Une telle calibration pour la recherche de la fréquence d'excitation optimale sera décrite plus en détail ci-dessous.

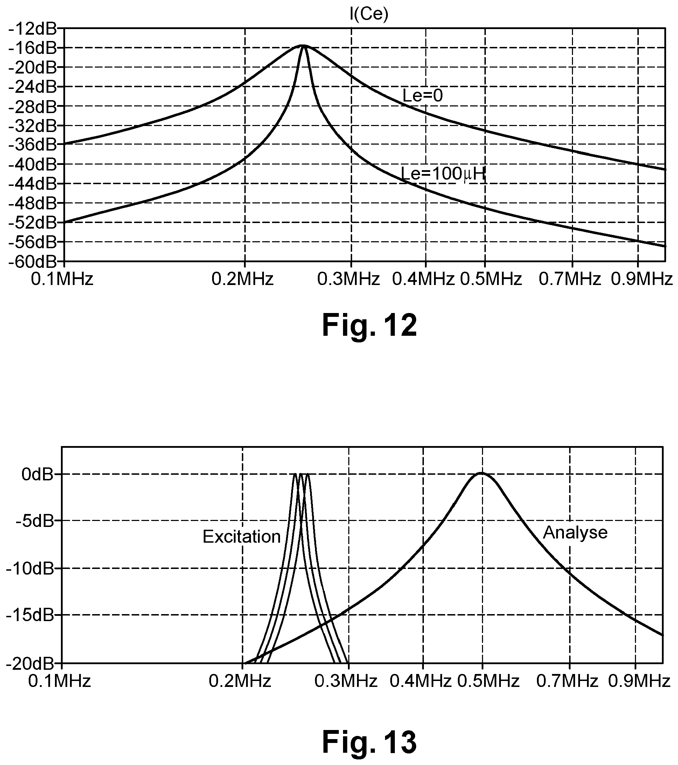

La figure 12 illustre l'amélioration du filtrage obtenu par ajout d'une inductance série Le dans le circuit d'excitation. I(Ce) est le courant circulant dans le condensateur Ce et donc le courant d'excitation. La fréquence de résonnance d'excitation Fres_e est 250kHz dans cet exemple et choisie égale à la fréquence d'excitation Fe. Un signal parasite présent dans la tension d'excitation à la fréquence d'analyse Fa = 2.Fe, soit à 500kHz, est ainsi atténué d'environ 32dB sans bobine Le série contre près de 50dB avec une bobine Le série de 100µH, ce qui représente presque un facteur 10.

### Mode de réalisation à 2 bobines SPM, Ze=Ce,Le et Za=Ca,La

Le montage de la figure 2 suppose un appairage quasi parfait des bobines SPM afin que seule la fréquence utile 2.Fe apparaisse dans le signal détecté au niveau du circuit de réception, à savoir le courant traversant l'impédance Za. Or, cet appairage parfait peut être difficile à obtenir en pratique, et le déséquilibre entre les bobines SPM induit au niveau du signal de sortie (à savoir le courant circulant dans l'impédance Za) une composante à la fréquence d'excitation Fe qui peut être d'amplitude très supérieure à la fréquence du signal utile, dégradant ainsi le rapport signal/bruit du système.

L'effet SPM dans une bobine SPM est modélisable par une source de tension dont le niveau est proportionnel au champ magnétique dans lequel est plongé la bobine SPM et dont l'impédance de source est constituée de la bobine SPM elle-même. Ainsi, si le circuit de réception (l'impédance Za) est constitué d'une résistance Ra et d'un condensateur Ca, le circuit de charge de la source de tension SPM est un circuit RLC série. On est donc à nouveau en présence d'un circuit passe-bande dont on positionnera la fréquence de résonnance à la fréquence d'analyse 2.Fe. La composante parasite à la fréquence Fe sera donc atténuée, le niveau d'atténuation étant d'autant plus élevé que le facteur de qualité de ce circuit est élevé. Si on se contente du condensateur, le facteur de qualité est très faible, puisqu'il est forcément inférieur à celui des bobines SPM du fait de l'ajout de la résistance de mesure Ra qui est en général supérieure à la résistance du circuit constitué par les bobines SPM. On peut donc compter sur un facteur de qualité de l'ordre de 2 à 3.

Ainsi, de la même manière que pour le circuit d'excitation, il est possible d'ajouter une inductance série dans l'impédance d'analyse Za du module de conditionnement pour augmenter significativement le facteur de qualité du circuit de conditionnement.

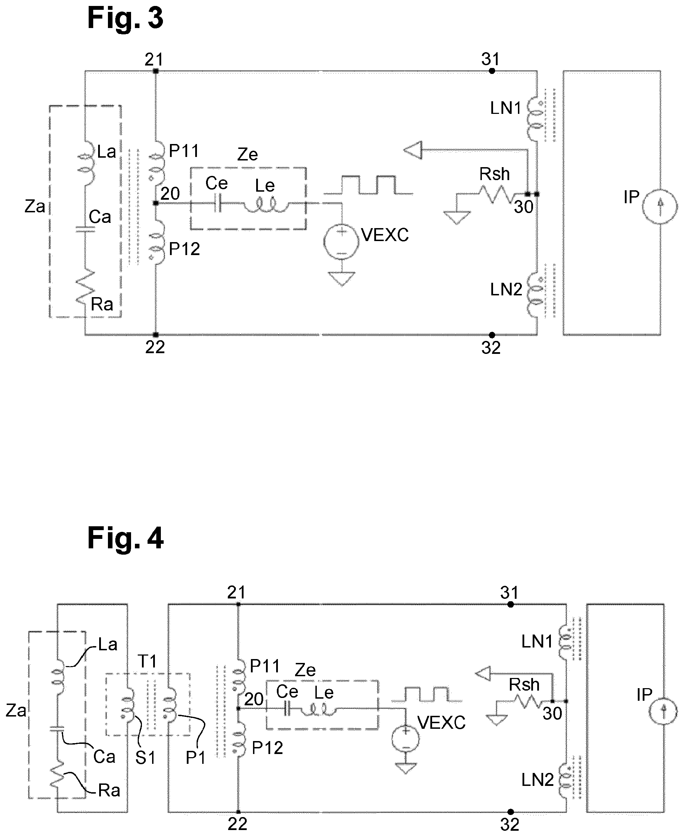

Le montage de la figure 3 correspond ainsi au montage de la figure 2 dans lequel l'impédance d'analyse Za comprend en outre une inductance d'analyse La. L'inductance La, le condensateur Ca et la résistance Ra sont ainsi montés en série entre les bornes extérieures 21, 22 de la bobine à point milieu P11/P12.

Dans cette configuration, la fréquence de résonance d'analyse Fres_a du circuit d'analyse vaut :

$$F_{res\_a} = \frac{1}{2\pi\sqrt{(L_a + 2L_N)C_a}}$$

Par ailleurs, si la fréquence d'analyse Fa est fixée à 2.Fe et si la fréquence d'excitation Fe a été prédéfinie pour maximiser le niveau de courant d'excitation, via par exemple une étape de calibration mentionnée ci-dessus, le facteur de qualité du circuit de conditionnement (ou circuit de réception) devra de préférence être limité de façon à ce que, en tenant compte des tolérances sur les composants La et Ca, l'atténuation reste raisonnable pour toutes les valeurs de fréquences envisageables pour la fréquence d'excitation Fe.

Par exemple, pour garantir une atténuation plus faible que 3dB avec une dispersion sur la fréquence d'excitation Fe de 3% et une dispersion sur la fréquence de résonnance du circuit d'analyse Fres_a également de 3%, une limitation à un coefficient de qualité de l'ordre 8 peut être considérée.

La figure 13 illustre un exemple concernant la différence de sélectivité recherchée entre l'excitation et l'analyse. La fréquence de résonnance de l'excitation peut varier du fait des tolérances sur les composants (ici +/-5% sur la valeur de la bobine série d'excitation). Il faut alors que la fréquence d'analyse qui est le double de la fréquence d'excitation soit dans la bande passante du filtre de réception.

### Mode de réalisation à 2 bobines SPM, Ze, Za et transformateur T1

Dans le montage illustré à la figure 4, un transformateur T1 est inséré entre la bobine à point milieu P11-P12 et l'impédance d'analyse Za, afin d'adapter l'impédance du circuit d'analyse et augmenter le niveau de sortie du signal reçu par l'impédance Za.

Le transformateur T1 est constitué par un enroulement primaire P1 et un enroulement secondaire S1. L'enroulement primaire P1 est connecté aux bornes extérieures 21, 22 de la bobine à point milieu P11-P12, et l'enroulement secondaire S1 est connecté aux bornes de l'impédance d'analyse Za.

Le fonctionnement de ce circuit est similaire à celui de la figure 3.

## Mode de réalisation à 2 bobines SPM, Ze, Za et transformateur T2

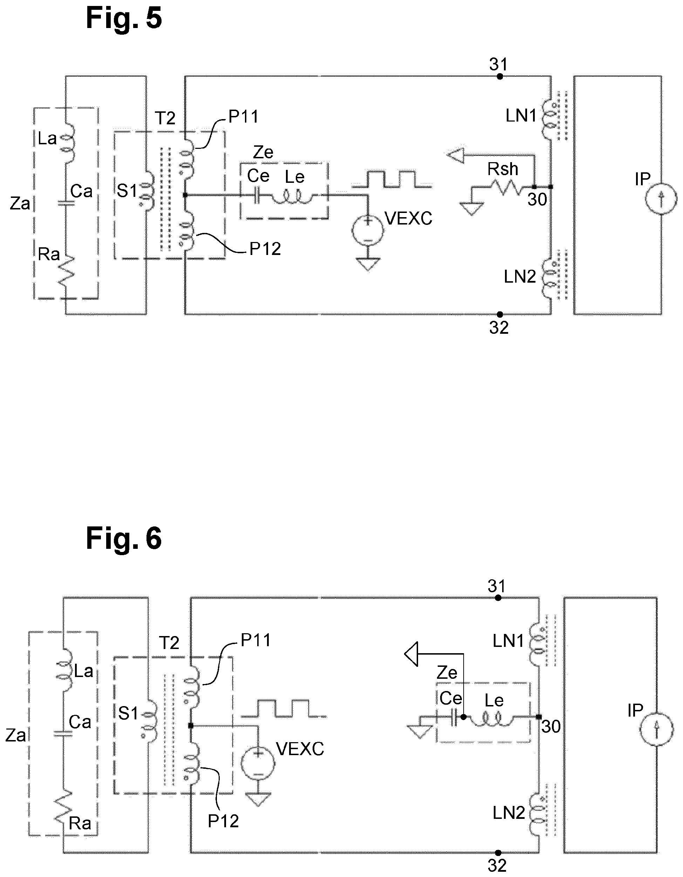

Dans le montage illustré à la figure 5, un unique transformateur T2 est utilisé pour réaliser les fonctions de la bobine à point milieu P11-P12 et du transformateur T1 du circuit de la figure 4. Ainsi, l'enroulement primaire du transformateur T2 qui est connecté aux bornes 31, 32 du transducteur est configuré pour réaliser la fonction de la bobine à point milieu de la figure 4 et l'enroulement secondaire qui est connecté aux bornes de l'impédance d'analyse Za est configuré pour réaliser la fonction d'adaptation du transformateur T1 du circuit de la figure 4.

## Mode de réalisation à 2 bobines SPM, position de l'impédance Ze

Dans le montage illustré à la figure 6, contrairement au montage de la figure 5, l'impédance d'excitation Ze est connectée entre la borne commune 30 du transducteur et le potentiel de référence.

L'intérêt de cette configuration réside notamment dans la possibilité de mesurer le courant d'excitation aux bornes du condensateur Ce par exemple, ce qui permet de supprimer la résistance de mesure Rsh tendant à dégrader le facteur de qualité du circuit, les mesures étant généralement référencées au potentiel de référence. Le facteur de qualité de l'excitation se trouve donc amélioré et la tension de mode commun au niveau du point milieu de la bobine P11-P12 et des bornes extérieures 31, 32 des bobines LN1, LN2 est réduite.

Les configurations illustrées aux figures 1 à 6 mettant en œuvre deux bobines SPM excitées par une seule fréquence d'excitation, sans circuit de contre-réaction, sont particulièrement adaptées pour des mesures où la linéarité de la réponse n'est pas un paramètre très important, en particulier lorsque la mesure est faite dans un environnement électromagnétique peu perturbé.

## Mode de réalisation à 2 bobines SPM, avec contre-réaction VCR

La configuration de la figure 6 précédente peut être améliorée par l'adjonction classique d'un circuit ou module de contre-réaction VCR. De façon classique, le principe de la contre-réaction consiste à ajuster la contre-réaction de manière à obtenir un signal de mesure SPM nul, et la valeur de la contre-réaction est alors directement proportionnelle au champ à mesurer. Cette configuration offre ainsi une bonne linéarité, et est particulièrement adaptée aux environnements électromagnétiques perturbés tout en conservant une certaine simplicité dans sa réalisation.

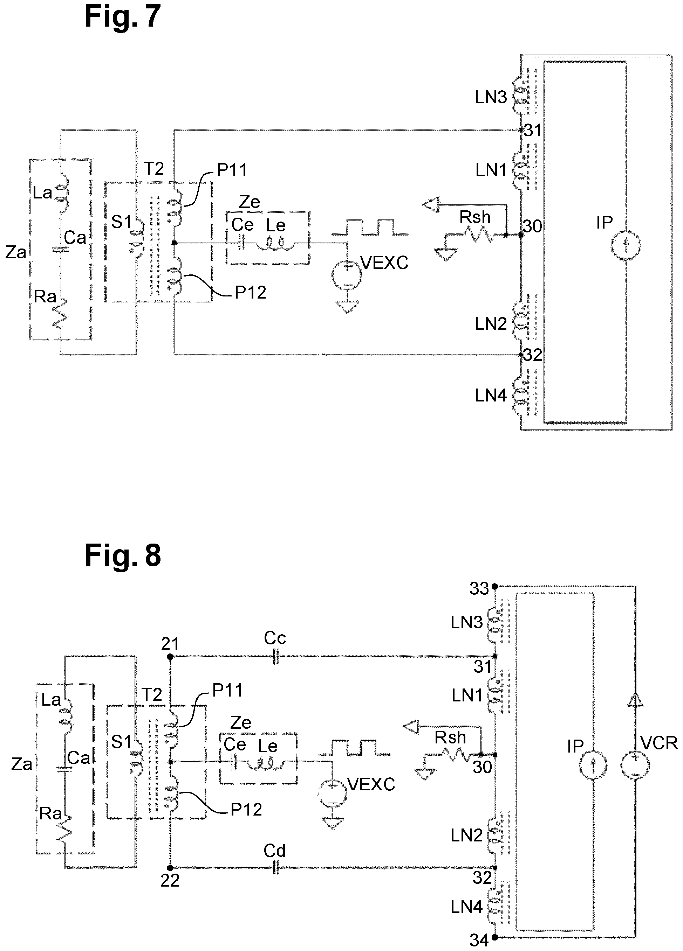

De façon similaire au montage de la figure 8, la contre-réaction peut ainsi être réalisée par l'ajout au montage de la figure 6, d'un générateur de tension de contre-réaction VCR aux bornes extrêmes 31, 32 du transducteur, d'un condensateur Cc entre les bornes 21, 31 et d'un autre condensateur Cd entre les bornes 22, 32.

Le générateur de tension de contre-réaction VCR est configuré pour générer un courant de contre-réaction, et les condensateur Cc et Cd, de même valeur $C_{CR}$, sont configurés pour éviter la circulation du courant de contre-réaction dans la bobine à point milieu P11-P12, de sorte que le courant de contre-réaction traverse uniquement les bobines SPM dans la plage de fréquences utiles. Par ailleurs, il peut également être judicieux d'isoler le générateur de tension de contre-réaction VCR du potentiel de référence par l'ajout par exemple d'un transformateur d'alimentation et d'un amplificateur isolé.

La fréquence de résonnance d'excitation Fres_e et la fréquence de résonnance d'analyse Fres_a sont bien entendues modifiées par la présence de ces condensateurs Cc et Cd formant circuit résonant.

Ainsi :

$$F_{res\_e} = \frac{1}{2\pi\sqrt{\left(L_e + \frac{L_N}{2}\right)C'_e}}\ ;$$

et

$$F_{res\_a} = \frac{1}{2\pi\sqrt{(L_a + 2L_N)C'_a}}$$

Avec :

$$C'_e = \frac{2C_e C_{CR}}{C_e + 2C_{CR}}\ ;$$

et

$$C'_a = \frac{1}{2}\frac{C_e C_{CR}}{C_e + \frac{C_{CR}}{2}}$$

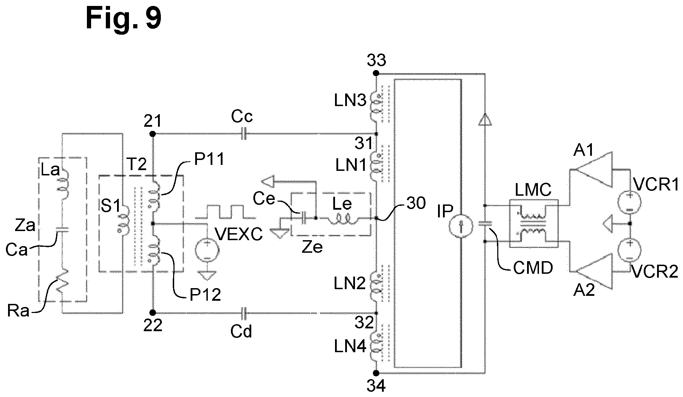

Dans une variante similaire au montage de la figure 9, le générateur de tension de contre-réaction VCR peut être formé de deux sources de tension VCR1 et VCR2 référencées au potentiel de référence. Les deux sources de tensions VCR1 et VCR2 sont configurées pour générer des tensions de même valeur VCR/2 mais de polarité opposée, et sont connectées aux bobines SPM LN1 et LN2 au travers d'amplificateurs A1 et A2 respectifs. En outre, pour supprimer le bruit de mode commun induit par ces deux sources de tensions VCR1 et VCR2, une inductance de mode commun LMC de valeur très supérieure à la valeur d'inductance des bobines SPM et à la valeur de l'inductance d'excitation Le, peut être ajoutée. Cette configuration permet d'éviter l'emploi d'une alimentation isolée et d'un amplificateur isolé, ce qui permet de réduire les coûts.

## Mode de réalisation à 4 bobines SPM, sans contre-réaction

Pour améliorer l'élimination d'un signal à la fréquence d'analyse Fa qui pourrait être présent dans le signal SPM du transducteur à 2 bobines SPM dans les montages des figures précédentes, et perturber ainsi la mesure, des bobines SPM supplémentaires LN3 et LN4 peuvent être ajoutées.

Par exemple, comme illustré à la figure 7, le montage de la figure 5 peut ainsi être modifié en couplant la première paire de bobines LN1 et LN2, à une deuxième paire de bobines super-paramagnétiques LN3 et LN4 sensiblement identiques aux bobines de la première paire.

En particulier, les bobines LN3 et LN4 de la deuxième paire sont montées en série et les deux paires de bobines sont montées en parallèle, de sorte que la borne extrême 31 de la première paire de bobines est connectée à la bobine LN3 et la borne extrême 32 de la première paire de bobine est connectée à la bobine LN4.

En pratique, les bobines SPM LN3 et LN4 sont soumises sensiblement aux mêmes champs magnétiques que les bobines SPM LN1 et LN2.

Ainsi, à la fréquence d'analyse Fa, la tension $e_{12}$ induite par la variation de champ, hors effet SPM, dans la première paire de bobines LN1 et LN2 est sensiblement identique à la tension induite $e_{34}$ dans la deuxième paire de bobines LN3 et LN4. Sur le montage de la figure 7, les points de polarité de chaque bobine sur le montage de la figure 9 par rapport au champ primaire sont tels que la tension entre les bornes extrêmes 31 et 32, développée par la première paire de bobines LN1 et LN2 est égale à la tension $e_{12}$, et la tension entre les bornes extrêmes 31 et 32 développée par la paire LN3 et LN4 est égale à -$e_{34}$. Les bobines SPM LN1 à LN4 étant d'impédance sensiblement identiques, la tension entre les bornes extrêmes 31 et 32 est alors égale à $e_{12}$/2-$e_{34}$/2, soit à peu près 0. En outre, les bobines LN3 et LN4 n'étant pas parcourues par le courant d'excitation Ie, elles ne produisent aucun effet SPM, et la tension SPM utile (VSPM) produite dans la première paire de bobines LN1 et LN2 se retrouve donc entre les bornes extrêmes 31 et 32 mais divisée par 2 par rapport à la configuration à une paire de bobines SPM de la figure 6.

Ainsi, bien que la sensibilité du circuit soit divisée par 2, cette configuration à quatre bobines SPM identiques plongées dans le même champ magnétique permet néanmoins de supprimer la composante primaire présente à la fréquence Fa.

## Mode de réalisation : 4 bobines SPM, avec contre-réaction VCR

Tout comme pour le mode de réalisation à 2 bobines, il est également possible d'adjoindre un circuit de contre-réaction VCR au montage de la figure 7, pour obtenir un capteur plus adapté aux environnements électromagnétiques perturbés.

Comme illustré à la figure 8, la contre-réaction peut ainsi être réalisée par l'ajout au montage de la figure 7, d'un générateur de tension de contre-réaction VCR entre les bobines LN3 et LN4 de la deuxième paire de bobines SPM. Le générateur VCR est ainsi monté entre les bornes extrêmes 33 et 34, et est configuré pour générer un courant de contre-réaction.

Des condensateurs Cc et Cd, de même valeur $C_{CR}$, positionnés respectivement sur les lignes de sortie, à savoir entre les bornes 21 et 31, et entre les bornes 22 et 32, sont configurés pour éviter la circulation du courant de contre-réaction dans la bobine à point milieu P11-P12, de sorte que le courant de contre-réaction traverse uniquement les bobines SPM dans la plage de fréquences utiles.

En pratique, le générateur de contre-réaction VCR présente une impédance faible à la fréquence d'analyse Fa. En outre, pour s'assurer que le courant d'excitation ne passe que par la première paire de bobines LN1 et LN2, il peut également être judicieux d'isoler le générateur de tension de contre-réaction VCR du potentiel de référence par l'ajout par exemple d'un transformateur d'alimentation et un amplificateur isolé.

La fréquence de résonance du circuit d'excitation Fres_e et la fréquence de résonance du circuit d'analyse Fres_a sont bien entendues modifiées par la présence de ces condensateurs Cc et Cd formant circuit résonant.

Ainsi :

$$F_{res\_e} = \frac{1}{2\pi\sqrt{\left(L_e + \frac{L_N}{2}\right)C_e'}};$$

et

$$F_{res\_a} = \frac{1}{2\pi\sqrt{(L_a + 2L_N)C_a'}}$$

Avec :

$$C_e' = \frac{2C_e C_{CR}}{C_e + 2C_{CR}};$$

et

$$C_a' = \frac{1}{2}\frac{C_e C_{CR}}{C_e + \frac{C_{CR}}{2}}$$

## Mode de réalisation : 4 bobines SPM, avec contre-réaction VCR1 et VCR2

La fonction de contre-réaction peut également être obtenue avec deux sources de tension VCR1 et VCR2 référencées au potentiel de référence, comme illustré à la figure 9. Les deux sources de tensions VCR1 et VCR2 sont configurées pour générer des tensions de même valeur VCR/2 mais de polarité opposée, et sont connectées aux bobines SPM au travers d'amplificateurs A1 et A2 respectifs.

Tout comme pour la figure 8, pour éviter l'utilisation de composants couteux liés à la réalisation d'une source de tension de contre-réaction isolée du potentiel de référence, on utilise deux générateurs de tension VCR1 et VCR2 connectés au potentiel de référence et une inductance de mode commun LMC insérée entre les générateurs et les bobines LN3 et LN4. L'inductance de mode commun LMC est de valeur très supérieure à la valeur d'inductance des bobines SPM et à la valeur de l'inductance d'excitation Le (de préférence dix fois supérieure). L'impédance de mode commun de la branche formée par les bobines LN3 et LN4 est alors augmentée significativement, forçant ainsi le courant d'excitation à circuler par les bobines LN1 et LN2.

Cependant, pour que les bobines LN3 et LN4 puissent remplir leur rôle, il doit exister un quasi-court-circuit entre les bornes externes du transducteur à la fréquence d'analyse Fa. Pour obtenir ce court-circuit, un condensateur CMD peut être placé entre les bornes externes du transducteur, ce qui permettra aux courants de mode différentiel, c'est-à-dire ceux circulant dans le même sens dans les bobines LN1 à LN4, de circuler correctement à la fréquence d'analyse Fa.

Ainsi, dans le montage de la figure 9 :

- la bobine de mode commun LMC permet d'empêcher la circulation du courant d'excitation dans la paire de bobines LN3 et LN4, tout en garantissant une bande passante élevée pour la boucle de contre-réaction ; et
- le condensateur CMD permet d'assurer un court-circuit de la paire de bobines LN3 et LN4 à la fréquence d'analyse Fa.

**Calibration pour la recherche de la fréquence optimale d'excitation**

Comme expliqué ci-dessus, l'impédance d'excitation Ze ajoutée pour l'atténuation de la composante harmonique au rang 2 permet d'atteindre un facteur de qualité de l'ordre de 30 à 50.

Cependant, le choix d'une fréquence d' excitation Fe fixe peut s'avérer incompatible avec un facteur de qualité élevé. L'amélioration du facteur de qualité peut s'accompagner d'une diminution non négligeable du courant d'excitation lorsque la fréquence d'excitation Fe s'écarte de la fréquence de résonnance d'excitation Fres_e du circuit d'excitation.

Une solution consiste ainsi à ajuster la fréquence du générateur d'excitation VEXC de façon à correspondre à une fréquence optimale d'excitation Fopt_e qui conduit à un niveau de courant d'excitation le plus élevé. En d'autres termes, en ajustant la valeur de la fréquence d'excitation Fe à celle de la fréquence optimale d'excitation Fopt_e, on maintient le courant d'excitation généré à un niveau acceptable.

En pratique, une unité de contrôle peut être couplée au module d'excitation et être configurée pour :

- lors d'une phase de calibration préalable (étapes 10 et 10') : rechercher la fréquence optimale d'excitation Fopt_e à injecter dans les bobines SPM ; et
- lors d'une phase d'exploitation (étape 11) pour la mesure d'un champ magnétique extérieur : commander le générateur de tension d'excitation VEXC pour générer une tension à une fréquence d'excitation sensiblement égale à la fréquence optimale d'excitation Fopt_e.

L'unité de contrôle peut être interne au capteur ou externe au capteur, et un moyen de stockage de la valeur de la fréquence optimale d'excitation peut être prévu dans le capteur.

La fréquence optimale d'excitation Fopt_e peut être obtenue en recherchant la fréquence d'excitation Fe pour laquelle le niveau de courant d'excitation le est maximum. Ainsi, la recherche de la fréquence optimale d'excitation Fopt_e peut être réalisée par mesure du courant d'excitation Ie lors de la phase de calibration au moyen de la résistance de mesure Rsh prévue dans les montages des figures 2-5, 7 et 8, ou au moyen du condensateur d'excitation Ce dans les montages des figures 6 et 9.

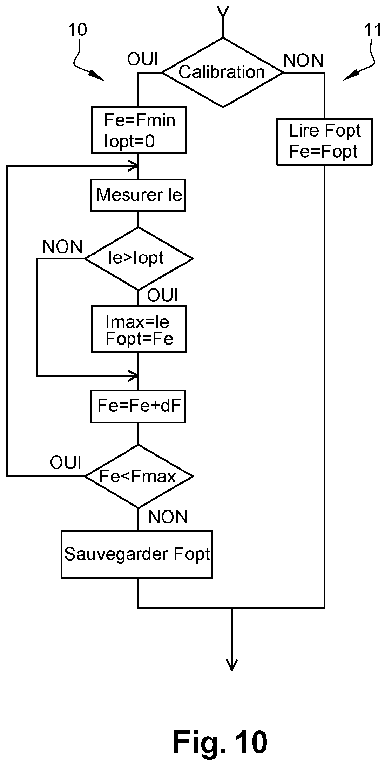

La figure 10 illustre de façon sommaire les étapes de recherche selon une méthodologie qui consiste à balayer la fréquence d'excitation Fe dans une plage de fréquences [Fe_min ; Fe_max], et à rechercher dans cette plage la fréquence d'excitation F_opt pour laquelle le courant d'excitation Ie mesuré par exemple via la résistance Rsh ou via le condensateur Ce, est maximal.

Une autre solution pour la phase de calibration consiste à rechercher la fréquence optimale d'excitation Fopt_e à injecter dans les bobines SPM pour laquelle la sensibilité du circuit est maximale.

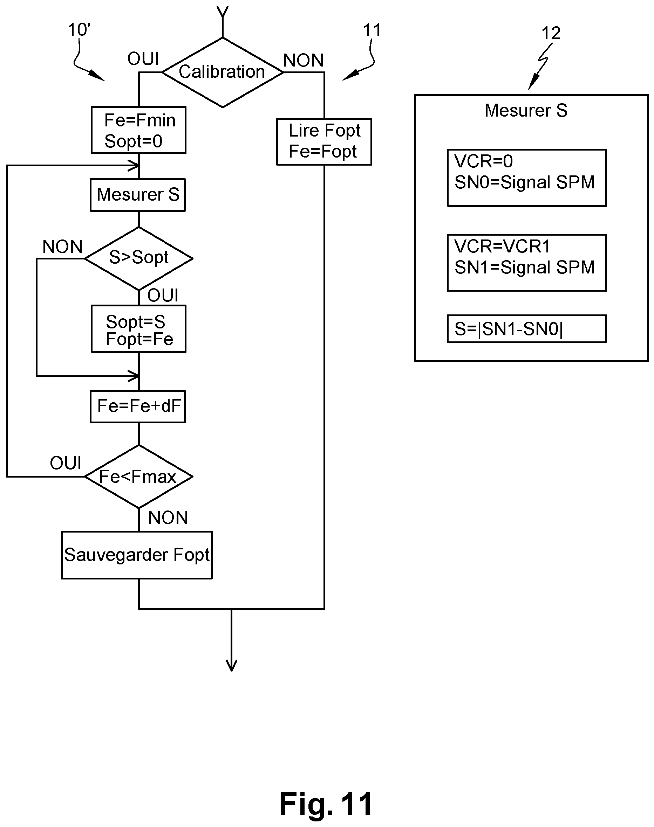

La figure 11 illustre de façon sommaire les étapes de recherche selon une autre méthodologie qui consiste à balayer la fréquence d'excitation Fe dans une plage de fréquences [Fe_min ; Fe_max], et à rechercher dans cette plage la fréquence d'excitation F_opt pour laquelle la sensibilité S du circuit est maximale.

La mesure de la sensibilité S (étape 12) du circuit peut être effectuée en mesurant la différence de niveau de signal SPM obtenue en faisant varier la tension de contre-réaction VCR entre deux niveaux prédéterminés VCRmin et VCRmax.

Les fréquences d'excitation et d'analyse Fe et Fa peuvent être ajustées par l'unité de contrôle respectivement dans les plages [Fe_min ; Fe_max] et [Fa_min ; Fa_max]. En pratique, la fréquence d'excitation Fe variera de quelques pourcents autour d'une fréquence nominale Fe_nom comprise entre quelques dizaines de kHz et quelques centaines de kHz. De même, la fréquence d'analyse Fa variera de quelques pourcents autour d'une valeur nominale Fa_nom également comprise entre quelques dizaines de kHz et quelques centaines de kHz, voire quelques MHz.

Dans une phase de calibration, on recherche une fréquence d'excitation optimale Fopt que l'on stocke dans une mémoire, puis lors de la phase d'exploitation, le module d'excitation est commandé pour générer le signal d'excitation à cette fréquence d'excitation optimale.

Le générateur de tension d'excitation VEXC peut être un générateur de signal carré, par exemple un générateur de type PWM (« pulse width modulation » ou « modulation à largeur d'impulsion »). Les configurations de la présente invention tolérant l'utilisation d'un signal d'excitation quasi sinusoïdal, le générateur de tension d'excitation VEXC peut également être un générateur à base d'un convertisseur analogique-numérique couplé à un filtrage et à une amplification de puissance.

La présente invention n'est bien entendu pas limitée aux exemples de réalisation décrits mais s'étend à toute modification et variante évidentes pour un homme du métier dans la limite des revendications annexées. En outre, les caractéristiques techniques des différents modes de réalisation et variantes mentionnés ci-dessus peuvent être, en totalité ou pour certaines d'entre elles, combinées entre elles.

## Revendications

1. Capteur de champ magnétique pour la mesure d'un courant continu, formé d'au moins un transducteur (3) à matériau super-paramagnétique SPM destiné à être soumis à un champ magnétique extérieur à mesurer, et couplé électriquement à un module d'excitation (2) et à un module d'analyse (1),

    - le transducteur comprenant au moins une paire de bobines (LN1, LN2) à noyau super-paramagnétique SPM, les bobines SPM étant sensiblement identiques et étant connectées en série entre deux bornes extrêmes (31, 32) du transducteur, le point de connexion commun (30) des bobines SPM (LN1, LN2) étant relié à un potentiel de référence ;
    - le module d'excitation (2) étant configuré pour générer et injecter dans le transducteur (1) un courant d'excitation Ie à une fréquence d'excitation Fe prédéfinie, et comprenant au moins :

        . une bobine (P11/P12) à point milieu (20) montée en parallèle aux bornes du transducteur ;
        . un générateur de tension d'excitation (VEXC) monté entre le potentiel de référence et ledit point milieu (20) ;
        . une impédance d'excitation (Ze) configurée pour former avec les bobines SPM (LN1, LN2) un premier circuit de type RLC série de fréquence de résonance Fres_e sensiblement égale à la fréquence d'excitation Fe ;

    - le module d'analyse (1) comprenant au moins :

        . une impédance d'analyse (Za) connectée aux bornes extérieures (21, 22) de la bobine à point milieu (P11/P12), l'impédance d'analyse (Za) étant configurée pour former avec les bobines SPM (LN1, LN2) un deuxième circuit de type RLC série de fréquence de résonance d'analyse Fres_a sensiblement égale à une fréquence d'analyse Fa ;
        . un moyen d'analyse du courant traversant l'impédance d'analyse (Za) à la fréquence d'analyse (Fa) pour extraire une composante à ladite fréquence d'analyse Fa égale à un multiple pair de la fréquence d'excitation Fe.

2. Capteur de champ magnétique selon la revendication 1, **caractérisé en ce que** ladite fréquence d'analyse Fa est égale à 2.Fe.

3. Capteur de champ magnétique selon la revendication 1 ou 2, **caractérisé en ce que** l'impédance d'excitation (Ze) est connectée entre le générateur d'excitation (VEXC) et le point milieu (20) de la bobine à point milieu (P11-P12).

4. Capteur de champ magnétique selon la revendication 1 ou 2, **caractérisé en ce que** l'impédance d'excitation (Ze) est connectée entre le potentiel de référence et le point de connexion commun (30) des bobines SPM (LN1, LN2).

5. Capteur de champ magnétique selon l'une des revendications 1 à 4, **caractérisé en ce que** l'impédance d'excitation (Ze) comprend au moins un condensateur d'excitation (Ce).

6. Capteur de champ magnétique selon l'une des revendications 1 à 5, **caractérisé en ce que** l'impédance d'excitation (Ze) comprend au moins un condensateur d'excitation (Ce) et une inductance d'excitation (Le), l'inductance d'excitation (Le) étant connectée entre le condensateur d'excitation (Ce) et le générateur de tension d'excitation (VEXC).

7. Capteur de champ magnétique selon l'une des revendications 1 à 6, **caractérisé en ce que** la bobine à point milieu (P11-P12) est constituée de deux enroulements sensiblement identiques bobinés sur un même noyau magnétique.

8. Capteur de champ magnétique selon l'une des revendications 1 à 7, **caractérisé en ce que** l'impédance d'analyse (Za) est constituée par un condensateur d'analyse (Ca) et une résistance d'analyse (Ra) montés en série entre les deux bornes extérieures (21, 22) de la bobine à point milieu (P11-P12).

9. Capteur de champ magnétique selon la revendication 8, **caractérisé en ce que** l'impédance d'analyse (Za) comprend en outre une inductance d'analyse (La) montée en série avec le condensateur d'analyse (Ca) et la résistance d'analyse (Ra) entre les bornes extérieures (21, 22) de la bobine à point milieu (P11/P12).

10. Capteur de champ magnétique selon l'une des revendications 1 à 9, caractérisé en qu'il comprend en outre un transformateur (T1) monté entre la bobine à point milieu (P11-P12) et l'impédance d'analyse (Za), ledit transformateur (T1) étant constitué par un enroulement primaire (P1) et un enroulement secondaire (S1), l'enroulement primaire (P1) étant connecté aux bornes extérieures (21, 22) de la bobine à point milieu (P11-P12), et l'enroulement secondaire (S1) étant connecté aux bornes de l'impédance d'analyse (Za).

11. Capteur de champ magnétique selon l'une des revendications 1 à 9, caractérisé en qu'il comprend en outre un transformateur (T2) comprenant un enroulement primaire formé de la bobine à point milieu (P11-P12) et d'un enroulement secondaire connecté aux bornes de l'impédance d'analyse (Za).

12. Capteur de champ magnétique selon l'une des revendications 1 à 9, **caractérisé en ce que** les bobines SPM (LN1, LN2) du transducteur forme une première paire de bobines SPM, et **en ce que** le capteur comprend en outre une deuxième paire de bobines SPM (LN3, LN4) sensiblement identique à ladite première paire de bobines SPM (LN1, LN2), les bobines SMP (LN3, LN4) de la deuxième paire étant montées en série, la borne extrême (31) de la première paire de bobines SPM (LN1, LN2) étant connectée à l'une des bobines (LN3) de la deuxième paire et la borne extrême (32) de la première paire de bobine SPM (LN1, LN2) étant connectée à l'autre bobine (LN4) de la deuxième paire.

13. Capteur de champ magnétique selon l'une des revendications 1 à 11, **caractérisé en ce qu'**il comprend en outre un module de contre-réaction, ledit module de contre-réaction comprend au moins un générateur de tension de contre-réaction (VCR) monté aux bornes extrêmes (31, 32) du transducteur et configuré pour générer un courant de contre-réaction.

14. Capteur de champ magnétique selon l'une des revendications 1 à 12, **caractérisé en ce qu'**il comprend en outre un module de contre-réaction, ledit module de contre-réaction comprend au moins un générateur de tension de contre-réaction (VCR) monté entre les bobines SPM (LN3, LN4) de la deuxième paire et configuré pour générer un courant de contre-réaction.

15. Capteur de champ magnétique selon la revendication 13 ou 14, **caractérisé en ce que** le générateur de tension de contre-réaction (VCR) est formé de deux sources de tension (VCR1, VCR2) référencées au potentiel de référence.

16. Capteur de champ magnétique selon l'une des revendications 1 à 15, **caractérisé en ce qu'**il comprend en outre un module de calibration configuré pour rechercher une valeur optimale Fopt de la fréquence d'excitation Fe à injecter dans le transducteur.

17. Capteur de champ magnétique selon la revendication 16, **caractérisé en ce que** le module de calibration est configuré pour :

   - faire varier la fréquence d'excitation Fe du générateur d'excitation (VEXC) dans une plage de fréquences [Fe_min ; Fe_max] et mesurer les courants d'excitation Ie correspondant ; et
   - identifier la fréquence optimale d'excitation Fopt_e correspondant à la fréquence d'excitation Fe pour laquelle le niveau de courant d'excitation Ie est maximum.

18. Capteur de champ magnétique selon la revendication 17 combinée à la revendication 3, **caractérisé en ce que** le module de calibration est configuré pour mesurer le courant d'excitation aux bornes d'une résistance montée entre le potentiel de référence et le point commun de connexion des bobines SPM (LN1, LN2) du transducteur.

19. Capteur de champ magnétique selon la revendication 17 combiné à la revendication 4, **caractérisé en ce que** le module de calibration est configuré pour mesurer le courant d'excitation aux bornes du condensateur d'excitation (Ce).

20. Capteur de champ magnétique selon la revendication 16, **caractérisé en ce que** le module de calibration est configuré pour :

   - faire varier la fréquence d'excitation Fe du générateur d'excitation (VEXC) dans une plage de fréquences [Fe_min ; Fe_max] et mesurer la sensibilité S du module d'excitation ;
   - identifier la fréquence optimale d'excitation Fopt_e correspondant à la fréquence d'excitation Fe pour laquelle ladite sensibilité S est maximale.

**Patentansprüche**

1.  Magnetfeldsensor zur Messung eines Gleichstroms, bestehend aus mindestens einem Wandler (3) aus superparamagnetischem SPM-Material, der einem zu messenden äußeren Magnetfeld ausgesetzt wird und elektrisch mit einem Erregermodul (2) und einem Analysemodul (1) verbunden ist,

    - wobei der Wandler mindestens ein Spulenpaar (LN1, LN2) mit einem superparamagnetischen SPM-Kern umfasst, die SPM-Spulen im Wesentlichen identisch sind und zwischen zwei Anschlüssen am Ende (31, 32) des Wandlers in Reihe geschaltet sind, und der gemeinsame Verbindungspunkt (30) der SPM-Spulen (LN1, LN2) mit einem Bezugspotential verbunden ist;
    - wobei das Erregermodul so konfiguriert ist, dass es einen Erregerstrom Ie mit einer vordefinierten Erregerfrequenz Fe erzeugt und in den Wandler (1) einspeist, und mindestens Folgendes umfasst:

        . eine Spule (P11/P12) mit Mittelpunkt (20), die den Anschlüssen des Wandlers parallelgeschaltet ist;
        . einen Generator der Erregerspannung (VEXC), der zwischen dem Bezugspotential und dem Mittelpunkt (20) angeschlossen ist;
        . eine Erregerimpedanz (Ze), die so konfiguriert ist, dass sie mit den SPM-Spulen (LN1, LN2) eine erste RLC-Reihenschaltung mit einer Resonanzfrequenz Fres_e bildet, die im Wesentlichen der Erregerfrequenz Fe entspricht;

    - wobei das Analysemodul (1) mindestens Folgendes umfasst:

        . eine Analyseimpedanz (Za), die mit den Außenanschlüssen (21, 22) der Mittelpunktspule (P11/P12) verbunden ist, wobei die Analyseimpedanz (Za) so konfiguriert ist, dass sie mit den SPM-Spulen (LN1, LN2) eine zweite RLC-Reihenschaltung mit einer Analyse-Resonanzfrequenz Fres_a bildet, die im Wesentlichen gleich einer Analysefrequenz Fa ist;
        . ein Mittel zur Analyse des Stroms, der bei der Analysefrequenz (Fa) durch die Analyseimpedanz (Za) fließt, um eine Komponente bei der Analysefrequenz Fa zu extrahieren, die einem geradzahligen Vielfachen der Erregerfrequenz Fe entspricht.

2.  Magnetfeldsensor nach Anspruch 1, **dadurch gekennzeichnet, dass** die Analysefrequenz Fa gleich 2.Fe ist.

3.  Magnetfeldsensor nach Anspruch 1 oder 2, **dadurch gekennzeichnet, dass** die Erregerimpedanz (Ze) zwischen dem Erregergenerator (VEXC) und dem Mittelpunkt (20) der Mittelpunktspule (P11-P12) angeschlossen ist.

4.  Magnetfeldsensor nach Anspruch 1 oder 2, **dadurch gekennzeichnet, dass** die Erregerimpedanz (Ze) zwischen dem Bezugspotential und dem gemeinsamen Verbindungspunkt (30) der SPM-Spulen (LN1, LN2) angeschlossen ist.

5.  Magnetfeldsensor nach einem der Ansprüche 1 bis 4, **dadurch gekennzeichnet, dass** die Erregerimpedanz (Ze) mindestens einen Erregerkondensator (Ce) umfasst.

6.  Magnetfeldsensor nach einem der Ansprüche 1 bis 5, **dadurch gekennzeichnet, dass** die Erregerimpedanz (Ze) mindestens einen Erregerkondensator (Ce) und eine Erregerinduktivität (Le) umfasst, wobei die Erregerinduktivität (Le) zwischen dem Erregerkondensator (Ce) und dem Erregerspannungsgenerator (VEXC) geschaltet ist.

7.  Magnetfeldsensor nach einem der Ansprüche 1 bis 6, **dadurch gekennzeichnet, dass** die Mittelpunktspule (P11-P12) aus zwei im Wesentlichen identischen Wicklungen auf demselben Magnetkern besteht.

8.  Magnetfeldsensor nach einem der Ansprüche 1 bis 7, **dadurch gekennzeichnet, dass** die Analyseimpedanz (Za) aus einem Analysekondensator (Ca) und einem Analysewiderstand (Ra) besteht, die zwischen den beiden Außenanschlüssen (21, 22) der Mittelpunktspule (P11-P12) in Reihe geschaltet sind.

9.  Magnetfeldsensor nach Anspruch 8, **dadurch gekennzeichnet, dass** die Analyseimpedanz (Za) außerdem eine Analyseinduktivität (La) umfasst, die mit dem Analysekondensator (Ca) und dem Analysewiderstand (Ra) zwischen den Außenanschlüssen (21, 22) der Mittelpunktspule (P11/P12) in Reihe geschaltet ist.

10. Magnetfeldsensor nach einem der Ansprüche 1 bis 9, **dadurch gekennzeichnet, dass** er außerdem einen Transformator (T1) umfasst, der zwischen der Mittelpunktsspule (P11-P12) und der Analyseimpedanz (Za) angeschlossen ist, wobei der Transformator (T1) aus einer Primärwicklung (P1) und einer Sekundärwicklung (S1) besteht, die Primärwicklung (P1) mit den Außenanschlüssen (21, 22) der Mittelpunktspule (P11-P12) und die Sekundärwicklung (S1) mit den Anschlüssen der Analyseimpedanz (Za) verbunden ist.

11. Magnetfeldsensor nach einem der Ansprüche 1 bis 9, **dadurch gekennzeichnet, dass** er außerdem einen Transformator (T2) mit einer Primärwicklung in Form einer Mittelpunktsspule (P11-P12) und eine Sekundärwicklung umfasst, die an die Anschlüsse der Analyseimpedanz (Za) angeschlossen ist.

12. Magnetfeldsensor nach einem der Ansprüche 1 bis 9, **dadurch gekennzeichnet, dass** die SPM-Spulen (LN1, LN2) des Wandlers ein erstes SPM-Spulenpaar bilden und dass der Sensor ferner ein zweites SPM-Spulenpaar (LN3, LN4) umfasst, das im Wesentlichen mit dem ersten SPM-Spulenpaar (LN1, LN2) identisch ist, wobei die SMP-Spulen (LN3, LN4) des zweiten Paares in Reihe geschaltet sind, der Anschluss am Ende (31) des ersten SPM-Spulenpaares (LN1, LN2) mit einer der Spulen (LN3) des zweiten Paares verbunden ist und der Anschluss am Ende (32) des ersten SPM-Spulenpaares (LN1, LN2) mit der anderen Spule (LN4) des zweiten Paares verbunden ist.

13. Magnetfeldsensor nach einem der Ansprüche 1 bis 11, **dadurch gekennzeichnet, dass** er außerdem ein Gegenkopplungsmodul umfasst, wobei das Gegenkopplungsmodul mindestens einen Generator für die Gegenkopplungsspannung (VCR) umfasst, der an den Anschlüssen am Ende (31, 32) des Wandlers angeschlossen und so konfiguriert ist, dass er einen Gegenkopplungsstrom erzeugt.

14. Magnetfeldsensor nach einem der Ansprüche 1 bis 12, **dadurch gekennzeichnet, dass** er außerdem ein Gegenkopplungsmodul umfasst, wobei das Gegenkopplungsmodul mindestens einen Generator für die Gegenkopplungsspannung (VCR) umfasst, der zwischen den SPM-Spulen (LN3, LN4) des zweiten Paares geschaltet und so konfiguriert ist, dass er einen Gegenkopplungsstrom erzeugt.

15. Magnetfeldsensor nach Anspruch 13 oder 14, **dadurch gekennzeichnet, dass** der Generator der Gegenkopplungsspannung (VCR) aus zwei Spannungsquellen (VCR1, VCR2) in Bezug auf das Bezugspotential besteht.

16. Magnetfeldsensor nach einem der Ansprüche 1 bis 15, **dadurch gekennzeichnet, dass** er außerdem ein Kalibriermodul umfasst, das so konfiguriert ist, dass es einen optimalen Wert Fopt der in den Wandler einzuspeisenden Erregerfrequenz Fe ermittelt.

17. Magnetfeldsensor nach Anspruch 16, **dadurch gekennzeichnet, dass** das Kalibriermodul konfiguriert ist, um:

   - die Erregerfrequenz Fe des Erregergenerators (VEXC) in einem Frequenzbereich [Fe_min; Fe_max] zu variieren und die entsprechenden Erregerströme zu messen; und
   - die optimale Erregerfrequenz Fopt_e zu ermitteln, die der Erregerfrequenz Fe entspricht, bei welcher der Erregerstrompegel Ie maximal ist.

18. Magnetfeldsensor nach Anspruch 17 in Kombination mit Anspruch 3, **dadurch gekennzeichnet, dass** das Kalibriermodul konfiguriert ist, um den Erregerstrom an den Anschlüssen eines Widerstands zu messen, der zwischen dem Bezugspotential und dem gemeinsamen Verbindungspunkt der SPM-Spulen (LN1, LN2) des Wandlers geschaltet ist.

19. Magnetfeldsensor nach Anspruch 17 in Kombination mit Anspruch 4, **dadurch gekennzeichnet, dass** das Kalibriermodul konfiguriert ist, um den Erregerstrom an den Anschlüssen des Erregerkondensators (Ce) zu messen.

20. Magnetfeldsensor nach Anspruch 16, **dadurch gekennzeichnet, dass** das Kalibriermodul konfiguriert ist, um:

   - die Erregerfrequenz Fe des Erregergenerators (VEXC) in einem Frequenzbereich [Fe_min; Fe_max] zu variieren und die Sensibilität S des Erregermoduls zu messen;
   - die optimale Erregerfrequenz Fopt_e zu ermitteln, die der Erregerfrequenz Fe entspricht, bei der die Sensibilität S maximal ist.

**Claims**

1. Magnetic field sensor for measuring a direct current, formed of at least one superparamagnetic SPM material transducer (3), intended to be subjected to an external magnetic field to be measured, and electrically coupled to an excitation module (2) and to an analysis module (1),

   - the transducer comprising at least one pair of coils (LN1, LN2) with superparamagnetic SPM core, the SPM coils being substantially identical and being connected in series between two extreme terminals (31, 32) of the transducer, the common connection point (30) of the SPM coils (LN1, LN2) being connected to a reference potential;
   - the excitation module (2) being configured to generate and inject an excitation current Ie into the transducer (1), at a predefined excitation frequency Fe, and comprising at least:

. one midpoint (20) coil (P11/P12) mounted in parallel to the terminals of the transducer;
. one excitation voltage generator (VEXC) mounted between the reference potential and said midpoint (20);
. one excitation impedance (Ze) configured to form with the SPM coils (LN1, LN2) a first series RLC-type circuit with a resonance frequency Fres_e substantially equal to the excitation frequency Fe.

- the analysis module (1) comprising at least:

. one analysis impedance (Za) connected to the external terminals (21, 22) of the midpoint coil (P11/P12), the analysis impedance (Za) being configured to form with the SPM coils (LN1, LN2) a second series RLC-type circuit with an analysis resonance frequency Fres_a substantially equal to an analysis frequency Fa;
. one means for analysing the current passing through the analysis impedance (Za) at the analysis frequency (Fa) to extract a component at said analysis frequency Fa equal to an even multiple of the excitation frequency Fe.

2. Magnetic field sensor according to claim 1, **characterised in that** said analysis frequency Fa is equal to 2.Fe.

3. Magnetic field sensor according to claim 1 or 2, **characterised in that** the excitation impedance (Ze) is connected between the excitation generator (VEXC) and the midpoint (20) of the midpoint coil (P11-P12).

4. Magnetic field sensor according to claim 1 or 2, **characterised in that** the excitation impedance (Ze) is connected between the reference potential and the common connection point (30) of the SPM coils (LN1, LN2).

5. Magnetic field sensor according to any one of claims 1 to 4, **characterised in that** the excitation impedance (Ze) comprises at least one excitation capacitor (Ce).

6. Magnetic field sensor according to any one of claims 1 to 5, **characterised in that** the excitation impedance (Ze) comprises at least one excitation capacitor (Ce) and one excitation inductor (Le), the excitation inductor (Le) being connected between the excitation capacitor (Ce) and the excitation voltage generator (VEXC).

7. Magnetic field sensor according to any one of claims 1 to 6, **characterised in that** the midpoint coil (P11-P12) consists of two substantially identical windings wound over one same magnetic core.

8. Magnetic field sensor according to any one of claims 1 to 7, **characterised in that** the analysis impedance (Za) is constituted by an analysis capacitor (Ca) and an analysis resistor (Ra) mounted in series between the two external terminals (21, 22) of the midpoint coil (P11-P12).

9. Magnetic field sensor according to claim 8, **characterised in that** the analysis impedance (Za) further comprises an analysis inductor (La) mounted in series with the analysis capacitor (Ca) and the analysis resistor (Ra) between the external terminals (21, 22) of the midpoint coil (P11/P12).

10. Magnetic field sensor according to any one of claims 1 to 9, **characterised in that** it further comprises a transformer (T1) mounted between the midpoint coil (P11-P12) and the analysis impedance (Za), said transformer (T1) being constituted by a primary winding (P1) and a secondary winding (S1), the primary winding (P1) being connected to the external terminals (21, 22) of the midpoint coil (P11-P12), and the secondary winding (S1) being connected to the terminals of the analysis impedance (Za).

11. Magnetic field sensor according to any one of claims 1 to 9, **characterised in that** it further comprises a transformer (T2) comprising a primary winding formed of the midpoint coil (P11-P12) and of a secondary winding connected to the terminals of the analysis impedance (Za).

12. Magnetic field sensor according to any one of claims 1 to 9, **characterised in that** the SPM coils (LN1, LN2) of the transducer forms a first pair of SPM coils, and **in that** the sensor further comprises a second pair of SPM coils (LN3, LN4) substantially identical to said first pair of SPM coils (LN1, LN2), the SPM coils (LN3, LN4) of the second pair being mounted in series, the extreme terminal (31) of the first pair of SPM coils (LN1, LN2) being connected to one of the coils (LN3) of the second pair and the extreme terminal (32) of the first pair of SPM coils (LN1, LN2) being connected to the other coil (LN4) of the second pair.

13. Magnetic field sensor according to any one of claims 1 to 11, **characterised in that** it further comprises a feedback module, said feedback module comprises at least one feedback voltage generator (VCR) mounted to the extreme terminals (31, 32) of the transducer and configured to generate a feedback current.

14. Magnetic field sensor according to any one of claims 1 to 12, **characterised in that** it further comprises a feedback module, said feedback module comprises at least one feedback voltage generator (VCR) mounted between the SPM coils (LN3, LN4) of the second pair and configured to generate a feedback current.

15. Magnetic field sensor according to claim 13 or 14, **characterised in that** the feedback voltage generator (VCR) is formed of two voltage sources (VCR1, VCR2) referenced at the reference potential.

16. Magnetic field sensor according to any one of claims 1 to 15, **characterised in that** it further comprises a calibration module configured to seek an optimal value Fopt of the excitation frequency Fe to be injected into the transducer.

17. Magnetic field sensor according to claim 16, **characterised in that** the calibration module is configured to:

   - vary the excitation frequency Fe of the excitation generator (VEXC) in a frequency range [Fe_min; Fe_max] and measure the corresponding excitation currents Ie; and
   - identify the optimal excitation frequency Fopt_e corresponding to the excitation frequency Fe for which the excitation current level Ie is maximum.

18. Magnetic field sensor according to claim 17 combined with claim 3, **characterised in that** the calibration module is configured to measure the excitation current at the terminals of a resistor mounted between the reference potential and the common connection point of the SPM coils (LN1, LN2) of the transducer.

19. Magnetic field sensor according to claim 17 combined with claim 4, **characterised in that** the calibration module is configured to measure the excitation current at the terminals of the excitation capacitor (Ce).

20. Magnetic field sensor according to claim 16, **characterised in that** the calibration module is configured to:

   - vary the excitation frequency Fe of the excitation generator (VEXC) in a frequency range [Fe_min; Fe_max] and measure the sensitivity S of the excitation module;
   - identify the optimal excitation frequency Fopt_e corresponding to the excitation frequency Fe for which said sensitivity S is maximum.

## Fig. 1

## Fig. 2

# Fig. 3

# Fig. 4

## Fig. 5

## Fig. 6

19

# Fig. 7

# Fig. 8

# Fig. 9

**Fig. 10**

**Fig. 11**

Fig. 12

Fig. 13

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- FR 2891917
- FR 2980581
- FR 3038063
- FR 3038063 A1